# EUROPEAN PATENT APPLICATION

(11) **EP 1 424 620 A1**
(43) Date of publication of application: **02.06.2004**
(21) Application number: 02738625.9
(22) Date of filing: 05.06.2002
(51) Int. Cl.: G06F 1/16, G06K 19/00, B42D 15/10

(54) **CARD-SHAPED MEDIUM**

(30) Priority: 06.09.2001 JP 2001270077
(71) Applicant: MELCO INC., Nagoya-shi, Aichi 460-0011 (JP)
(72) Inventor: NOGUCHI, Wataru, c/o Melco Inc., Nagoya Center, Nakamura-ku, Nagoya-shi, Aichi 450-0003 (JP)
(74) Representative: Sturt, Clifford Mark
(86) International application number: PCT/JP2002/005571
(87) International publication number: WO 2003/023584

(57) **Abstract**

A card-shaped medium which can easily be attached and detached into/from a computer slot might be easily stolen. Mounting holes (14, 15) are formed at a back part (13) of a PC card (10) exposed when the PC card (10) is mounted in a slot (21) of a computer (20). An antitheft wire (30) mounted on the computer side mounting block (24) is fitted to the mounting holes (14, 15) , so that the PC card cannot be removed from the computer (20), thereby preventing theft of the PC card (10). Moreover, by mounting a retaining member M in the mounting hole (15), it is possible to improve the directivity of a transmitting antenna (17).

## Description

### Technical Field

This invention relates to a card-shaped medium.

### Background Art

A known card-shaped medium has a rectangular body. The card-shaped medium is adapted for use for a computer as a PC card. The PC card is so designed as to allow its back part to be exposed when its front part is fixed to a slot of the computer. The back part is available for a user to grip it for inserting/removing the card into/from the computer. There is also a card-shaped medium used as a radio card. The radio card has a built-in transmitting antenna that allows emitting a radio wave dependent on the directivity of the antenna.

### Disclosure of the Invention

The card-shaped medium that can easily be attached and detached into/from a computer slot might be easily stolen. On the other hand, the card-shaped medium used as a radio card suffers a problem where its built-in antenna hinders promising improvement of its directivity.

In view of the problems, a primary object of the present invention is to provide a card-shaped medium capable of protecting the medium against theft by means of such an antitheft device as a wire to be mounted on a computer body, and improving the directivity of its built-in transmitting antenna.

To achieve the object, according to the invention of Claim 1, a card-shaped medium body is so designed as to allow its back part to be exposed when its front part is fixed into a slot of a computer, and to have mounting holes formed at its back part. The mounting holes are formed open available for use in fitting the predetermined member to the back part.

According to the invention of Claim 1, a card shaped-medium, substantially rectangular in shape, has a card body including a front part to be inserted in a slot formed in a computer, and a back part that projects from the computer when the front part is inserted in the slot of the computer; wherein the back part is provided with mounting holes through which predetermined members are mounted.

Forming such mounting holes at a back part that projects from the computer permits a card-shaped medium to be available for use in mounting a predetermined member onto the card-shaped medium. The predetermined member has various alternatives. As some examples of it, such antitheft tools as wire, key, etc. may be used that prevent the card-shaped medium from being removed by a theft. As another alternative, such a retaining member as described later may also be available. The card-shaped medium has also various alternatives. As the card-shaped medium, a PC or IC card may be acceptable.

According to the invention of Claim 2, as one example of forming the mounting holes of Claim 1, the mounting holes are formed in projections projecting backward from the end surface of the back part such that the axes thereof extend substantially parallel to the long sides of the card body. In the invention of Claim 2, the mounting holes are formed in projections projecting backward from the end surface of the back part such that the axes thereof extend substantially parallel to the long sides of the card body.

According to the invention of Claim 3, as another example of forming the mounting holes of Claim 1, the mounting holes are formed in projections laterally projecting from the side surfaces of the back part such that the axes thereof extend substantially perpendicularly to a plane including a major surface of the card body. In the invention of Claim 3 thus configured, the mounting holes are formed in projections laterally projecting from the side surfaces of the back part such that the axes thereof extend substantially perpendicularly to a plane including a major surface of the card body.

According to the invention of Claim 4, as another example of forming the mounting holes of Claim 1, the mounting holes are formed in projections projecting backward from the end surface of the back part such that the axes thereof extend substantially parallel to the short sides of the card body. In the invention of Claim 4 thus configured, the mounting holes are formed in projections projecting backward from the end surface of the back part such that the axes thereof extend substantially parallel to the short sides of the card body.

According to the invention of Claim 5, as another example of forming the mounting holes of Claim 1, the mounting holes are formed in projections projecting backward from the end surface of the back part such that the axes thereof extend substantially perpendicularly to a plane including a major surface of the card body. In the invention of Claim 5 thus configured, the mounting holes are formed in projections projecting backward from the end surface of the back part such that the axes thereof extend substantially perpendicularly to a plane including a major surface of the card body.

According to the invention of Claim 6, as another example of forming the mounting holes of Claim 1, the mounting holes are formed in projections projecting upward from the upper surface of the back part or in projection projecting downward from the lower surface of the back part such that the axes thereof extend substantially parallel to the long sides of the card body. In the invention of Claim 6 thus configured, the mounting holes are formed in projections projecting upward from the upper surface of the back part or in projection projecting downward from the lower surface of the back part such that the axes thereof extend substantially parallel to the long sides of the card body.

According to the invention of Claim 7, as another example of forming the mounting holes of Claim 1, the mounting holes are formed in projections projecting upward from the upper surface of the back part or in projection projecting downward from the lower surface of the back part such that the axes thereof extend substantially parallel to the short sides of the card body. In the invention of Claim 7 thus configured, the mounting holes are formed in projections projecting upward from the upper surface of the back part or in projection projecting downward from the lower surface of the back part such that the axes thereof extend substantially parallel to the short sides of the card body.

According to the invention of Claim 8, as another example of forming the mounting holes of Claim 1, the mounting holes are formed so as to extend between the upper and the lower surface of the back part. In the invention of Claim 8, the mounting holes are formed so as to extend between the upper and the lower surface of the back part.

The mounting holes are preferably used for attaching a transmitting antenna to them. The antenna arranged in them improves the directivity of the antenna. According to the invention of Claim 9, the card-shaped medium of any one of claims 1 to 8 further comprises: a retaining member to be passed through the mounting hole; a transmitting antenna embedded in the card body; and a grounding part connected to a grounding terminal for the transmitting antenna and capable of coming into contact with part of the retaining member as passed through the mounting hole. In the invention of Claim 9 thus configured, the card-shaped medium comprises a retaining member to be passed through the mounting hole; a transmitting antenna embedded in the card body; and a grounding part connected to a grounding terminal for the transmitting antenna and capable of coming into contact with part of the retaining member as passed through the mounting hole. This configuration allows the retaining member to function as antenna reflector, thereby improving the directivity of the transmitting antenna.

According to the invention of Claim 10, in the card-shaped medium of claim 9, the grounding part is formed on the side surface of the mounting hole.

In the invention of Claim 10 thus configured, the grounding part is formed on the side surface of the through hole.

According to the invention of Claim 11, referring to the shape of the afore-mentioned retaining member and how to mount it on a given position, the card-shaped medium of Claim 9 or 10 is described. In the card-shaped medium, the retaining member is formed a shape substantially resembling the letter L by perpendicularly connecting first and second retaining parts, the first retaining part is passed through the hole extending between the upper and the lower surface of the back part, and the second part is placed on the upper or the lower surface of the back part.

In the invention of Claim 11 thus configured, in the card-shaped medium, the retaining member is formed a shape substantially resembling the letter L by perpendicularly connecting first and second retaining parts, the first retaining part is passed through the hole extending between the upper and the lower surface of the back part, and the second part is placed on the upper or the lower surface of the back part.

According to the invention of Claim 12, referring to how to mount the retaining member on a given position so as to improve the directivity of a transmitting antenna, the card-shaped medium of claim 11 is described. In the card-shaped medium, the transmitting antenna is extended substantially perpendicularly to a direction in which the card body is inserted in the slot, and the second retaining part is disposed in parallel to the transmitting antenna on the upper or the lower surface of the back part.

In the invention of Claim 12 thus configured, the configuration where the second retaining part is disposed in parallel to the transmitting antenna on the upper or the lower surface of the back part, permits the directivity of the antenna to be improved.

According to the invention of Claim 13, referring to the configuration where a card-shaped medium may be provided with an appropriate antitheft wire even if the computer mounting location should differ, the card-shaped medium of any one of claims 1 to 12 is described. In the card-shaped medium, the mounting holes are arranged symmetrically with respect to the longitudinal center axis of the card body.

In the invention of Claim 13 thus configured, the mounting holes are arranged symmetrically with respect to the longitudinal center axis of the card body.

The back part of the card-shaped medium preferably has a user-friendly design for inserting/removing the card into/from the computer.

According to the invention of Claim 14, the card-shaped medium of any one of claims 1 to 13, wherein the side surfaces of the back part are formed in an antislipping morphology.

In the invention of Claim 14 thus configured, the side surfaces of the back part are formed in an antislipping morphology.

### Brief Description of Drawing

Figure 1 is a block diagram showing a configuration of a PC card applied as a card-shaped medium of the present invention.
Figure 2 is an external view showing how a PC card is mounted on a computer.
Figure 3 is a sectional view showing how a PC card is mounted on a computer.
Figure 4 is a block diagram showing an embodiment of the configuration designed to prevent theft of a PC card.
Figure 5 is a top view of a computer.
Figure 6 is a block diagram showing a configuration of a PC card with an available radio means.
Figure 7 is an external view of a retaining member to be secured onto a mounting hole.
Figure 8 is a schematic showing how a retaining member is secured onto a mounting hole.
Figure 9 is a block diagram showing the substrate of the back part in a PC card in a condition where its sheath is removed.
Figure 10 is an enlarged view showing a magnification of the elements in the ground area.
Figure 11 is an enlarged view showing an exemplar variant of the ground area.
Figure 12 shows a directivity curve in case where a retaining member is not secured onto a mounting hole.
Figure 13 is a directivity curve in case where a retaining member is secured onto a mounting hole.
Figure 14 is a block diagram of the PC card showing the first variant example of a mounting hole.
Figure 15 is a block diagram of the PC card showing the second variant example of a mounting hole.
Figure 16 is a block diagram of the PC card showing the third variant example of a mounting hole.
Figure 17 is a block diagram of the PC card showing the fourth variant example of a mounting hole.
Figure 18 is a block diagram of the PC card showing the fifth variant example of a mounting hole.
Figure 19 is a block diagram of the PC card showing the sixth variant example of a mounting hole.
Figure 20 is a block diagram of the PC card wherein the side surfaces of the back part are formed in an antislipping morphology.

### Best Mode for Carrying Out The Invention

The preferred embodiments of the invention is described hereunder in the following order:
(1) PC Card Configuration,
(2) Antitheft Means,
(3) Transmitting Antenna Directivity Improvement,
(4) PC Card Variant Examples,
(5) Summary

### (1) PC Card Configuration

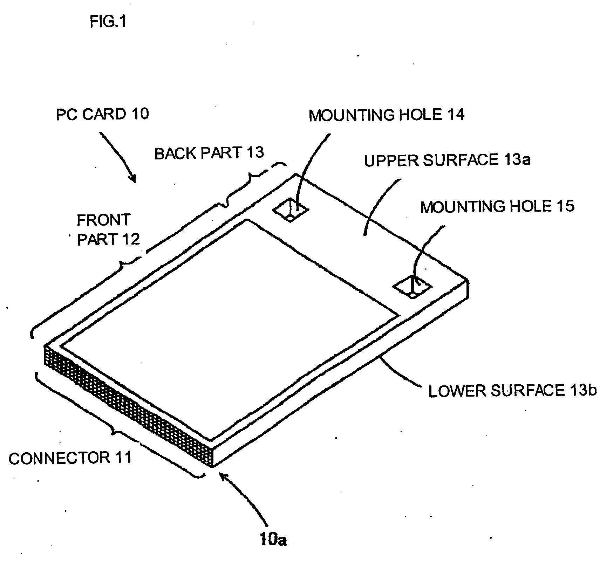

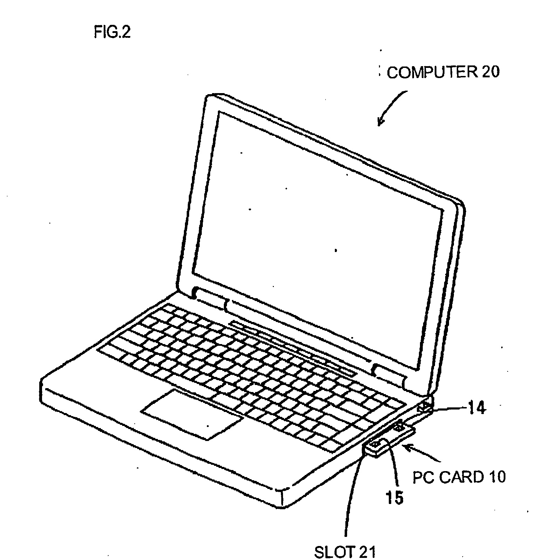

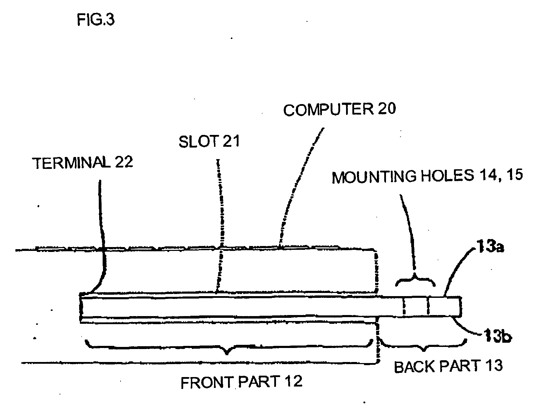

Figure 1 is a block diagram showing a configuration of the PC card applied as a card-shaped medium of the present invention. Figure 2 is an external view showing how such PC card is mounted on a computer. Figure 3 is a sectional view showing how the PC card is mounted on a computer. In the Figure 1, PC Card 10 is almost rectangularly shaped. Front part end 10a has Connector 11 to be connected with Terminal 22, which is laid out to the deeper side of Slot 21 formed on the side of Computer 20. When PC Card 10 is mounted in Slot 21 of Computer 20, Front part 12 is incorporated inside Slot 21. Back part 13 protrudes out of Slot 21 so as to be exposed, available for a user to grip Back part 13 for attaching / detaching PC Card 10 to and from Slot 21 on Computer 10. Such configuration where PC Card 10 is readily attachable / detachable has a risk in which PC Card 10 might be removed by a theft.

This embodiment provides an antitheft wire etc. mountable on PC Card 10. The antitheft wire etc. is to be attached to Mounting Holes 14 and 15 that are formed on exposed part of Back part 13 when PC Card 10 is in Computer 20. Mounting Holes 14 and 15 are through holes that are formed into a substantially square shape such that the axes thereof extend substantially perpendicularly from Upper Surface 13a to Lower Surface 13b. The form of Mounting Holes 14 and 15 is not limited to be substantially square only, but has wide variety of alternatives; either circular or polygonal shape may be acceptable. Mounting Holes 14 and 15 are used such that one end of the antitheft wire etc. is attached to either of Mounting Holes 14 and 15 while the other end of the wire is fixed to such fixture as Computer 20, allowing PC Card 10 to be protected against theft.

### (2) Antitheft Means

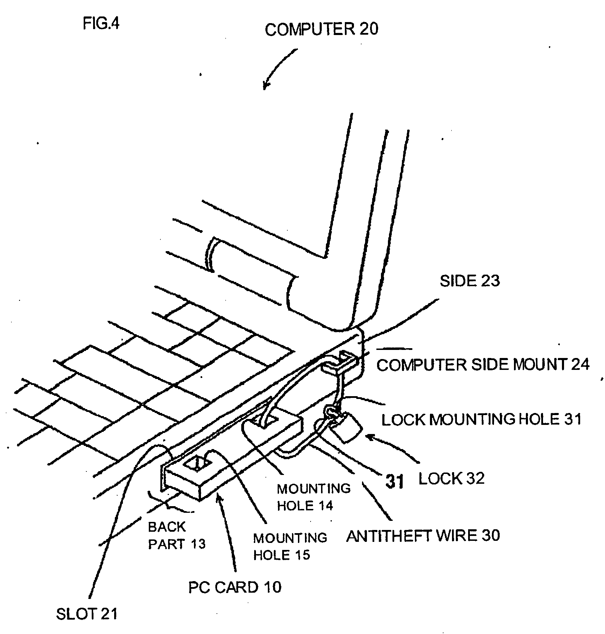

Figure 4 is a block diagram showing an embodiment of the configuration designed to prevent theft of a PC card, using Mounting Holes 14 and 15.

Expanded in the figure are the elements in the case where PC Card 10 is mounted in Slot 21 of Computer 20. With PC Card 10 mounted in Slot 21, Back part 13 is partially exposed as described above. In this embodiment, explained is Computer 20 that has Computer Side Mount 24. Computer Side Mount 24 is a through hole and formed on Side 23a so as to project externally.

With PC Card 10 mounted in place, one end of Antitheft Wire 30 is fitted to either Mounting Hole 14 or 15 and the other end of it is fitted to Computer Side Mount 24. In this embodiment, Antitheft Wire 30 is fitted to Mounting Hole 14 facing Computer Side Mount 24. This Antitheft Wire 30 is designed to have Lock Mounting Holes 31 and 31 formed at its end. After fitting Antitheft Wire 30 to Mounting Hole 14 or 15 and on Computer Side Mount 24, Lock 32 is fitted to Lock Mounting Holes 31 and 31 so that the wire will form a ring to prevent PC Card 10 from being removed from Computer 20. This permits of antitheft for PC Card 10.

In this embodiment, Back part 13 has Mounting Holes 14 and 15 formed symmetrically to the short sides of PC Card 10.

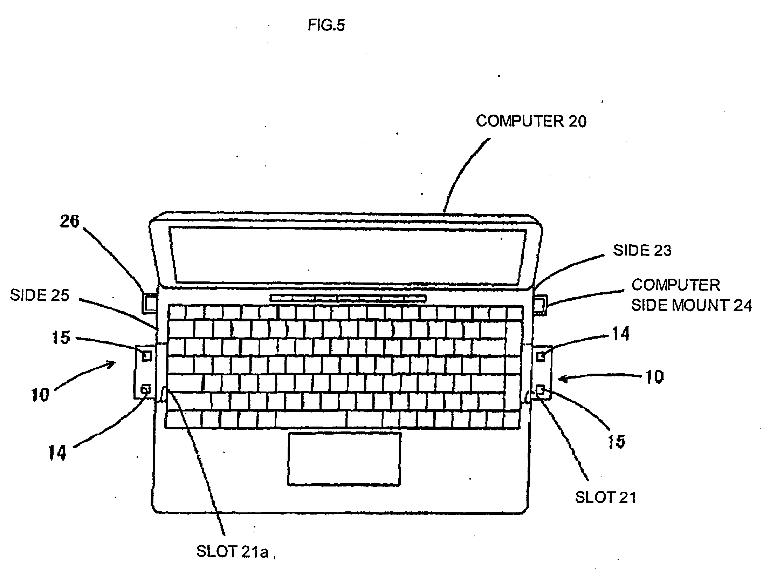

The reason for this is described as follows. As shown in Fig. 5, Computer 20 has Computer Side 25 symmetrical to Computer Side 23. To this Computer Side, Computer Side Mount 26 and Slot 21a are formed. In this case, Mounting hole 15 faces Computer Side Clamp 15. Therefore, Antitheft Wire 30 is fitted to Mounting Hole 15 and Computer Side Mount 26 so that PC Card 10 cannot be removed from Computer 20.

In other words, Mounting Holes 14 and 15 are formed symmetrically to the short sides of PC Card 10. With this configuration, Antitheft Wire 30 may be adequately mounted at the shortest distance, at whichever Side 23 or 25 of Computer 20 Computer Side Mounts 24 and 26 and Slots 21 and 21a may be formed. As a matter of course, Mounting Holes 14 and 15 are not limited to a configuration where they are formed symmetrically to the short sides of PC Card 10. Needless to say, either Mounting Hole 14 or 15 may be formed at either location at Back part 13.

As described above, Mounting Holes 14 and 15 are formed at Back part 13 of PC Card 10. At the same time, one end of Antitheft Wire 30 is fitted to Mounting Hole 14 or 15 and the other end of it is fitted to Computer Side Mount 24 or 26 of Computer 20, enabling PC Card 10 to be prevented from being freely removed and stolen. Here, PC Card 10 is a card type peripheral of function enhancement for Computer 20. And a wide variety of functions are coverable with such device as modem card, LAN card, SCSI card.

As a configuration to implement these functions, a wire cable may be mounted to PC Card 10 so that the function of the PC Card 10 may be implemented by way of such cable. With a transceiver antenna provided on PC Card 10, the function may also be implemented by way of a radio wave.

This transmitting antenna is designed to have a given directivity and be laid out on a substrate inside PC Card 10. This directivity of the antenna cannot be altered once PC Card 10 has been fabricated such that a transmitting antenna is laid out on its substrate. In this embodiment, therefore, a retaining member later described is secured onto Mounting Hole 15 formed on Back part of PC Card 10 as an antitheft means described above, enabling the directivity of the transmitting antenna to be improved.

### (3) Transmitting antenna Directivity Improvement,

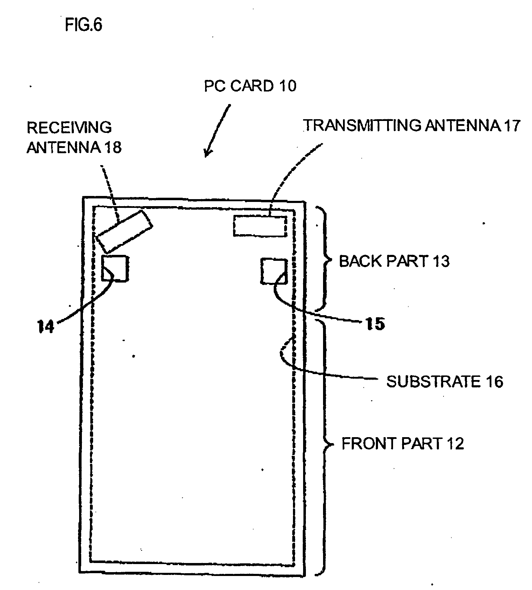

Figure 6 is a block diagram showing a configuration of a PC card in which a radio means is realizable.

In Figure 6, PC Card 10 has built-in Substrate 16 to implement a radio function. Substrate 16 has Transmitting antenna 17 and Receiving Antenna 18 at the end of Back part 13 to transmit and receive radio waves, respectively. In this embodiment, Mounting Hole 15 is formed around Transmitting antenna 17. At the same time, a retaining member is secured onto this Mounting Hole 15 so that the retaining member has the function as a reflector for Transmitting antenna 17 for improving the directivity.

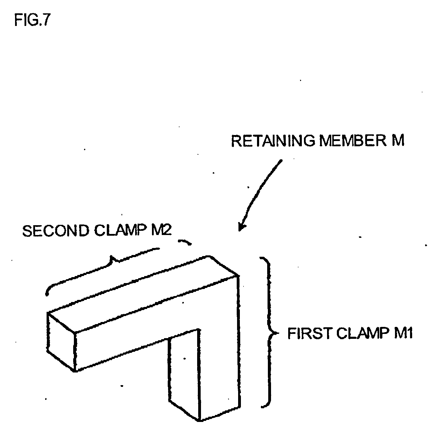

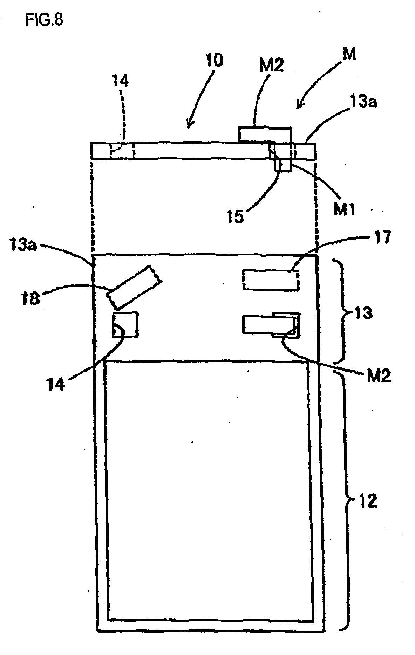

Figure 7 is an external view of a retaining member to be secured onto Mounting Hole 15. Figure 8 is a schematic showing how a retaining member is secured onto Mounting Hole 15. In the figure 7, Retaining member M is substantially L-shaped. In this case, Retaining member M is composed of First Clamp M1 and Second Clamp M2, being nearly L-shaped by folding Second Clamp M2 almost vertically from the end of First Clamp M1. When securing this Retaining member M onto Mounting Hole 15, First Clamp M1 is inserted in Mounting Hole 15 while Second Clamp M is laid out on Upper Surface 13a at Back part 13 so that Second Clamp M2 is in parallel with Transmitting antenna 17. Laying out Second Clamp M2 in parallel with Transmitting antenna 17 allows Retaining member M to function as a reflector of Transmitting antenna 17, improving the directivity of the Transmitting antenna 17.

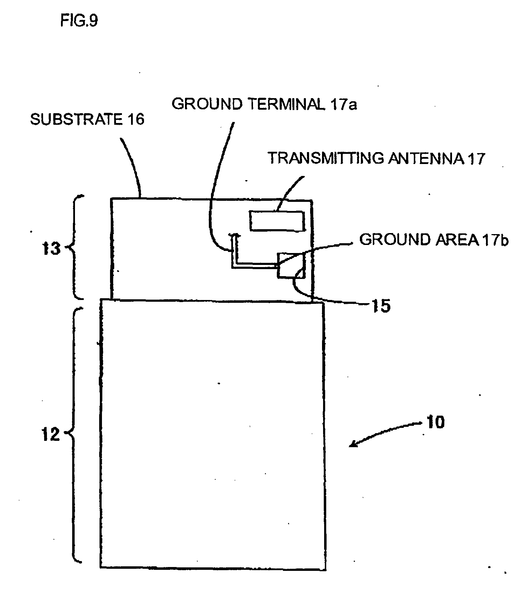

In order to make Retaining member M function as reflector of Transmitting antenna 17 as referred to above, it is necessary to connect Retaining member M to Transmitting antenna 17 at the ground terminal. Subsequently described, therefore, is how to connect this ground terminal with Retaining member M. Figure 9 is a block diagram showing Substrate 16 exposed with the sheath removed at Back part 13 of PC Card 10. In the figure, Ground Terminal 17a is wired on Substrate 16 to ground Transmitting antenna 17. In this embodiment, this Ground Terminal 17a is extended up to the outer frame of Mounting Hole 15 formed on Substrate 16. Thus, Ground Terminal 17a is formed so as to come into contact with First Clamp M1 on Retaining member M inserted in Mounting Hole 15.

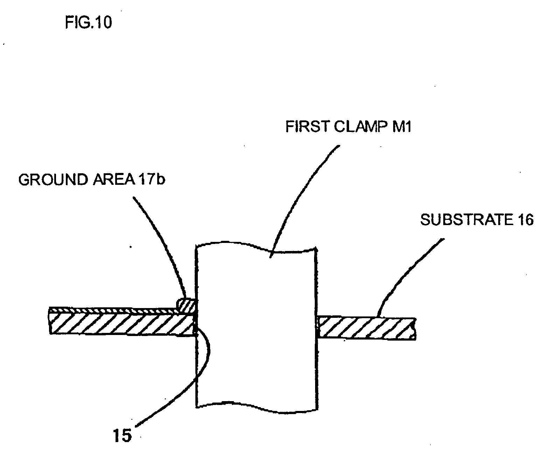

Figure 10 is an enlarged view showing a magnification of the elements in Ground Area 17b.

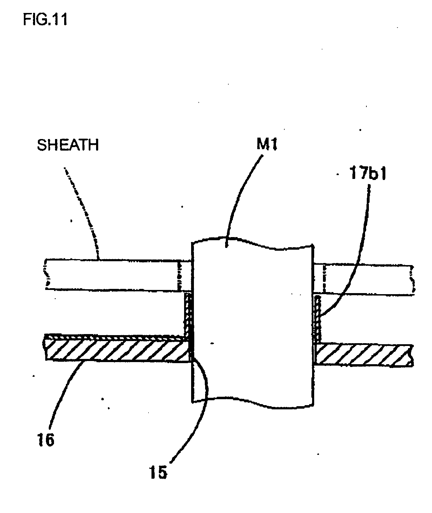

In Figure 10, First Clamp M1 on Retaining member M inserted in Mounting Hole 15 formed on Substrate 16 comes in contact with Ground Area 17b formed to protrude slightly inwards from the external frame of Mounting Hole 15, enabling Retaining member M to function as a reflector of Transmitting antenna 17. Ground Area 17b is not limited to such a configuration as to be laid out as part of the outer frame of Mounting Hole 15 formed on Substrate 16 as shown in Figures 9 and 10. Figure 11 is an enlarged view showing an exemplar variant of Ground Area 17b. Figure 11 is a sectional view. It is preferable that Metal Frame 17b1 may be molded into a substantial shape of Mounting Hole 15, with Ground Area 17b laid out between Substrate 16 and the sheath. This will cause First Clamp M1 to come into contact with Ground Area 17b1 without fail so that Transmitting antenna 17 may improve its directivity.

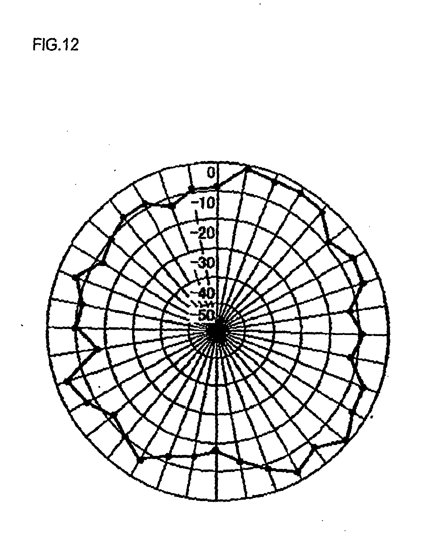

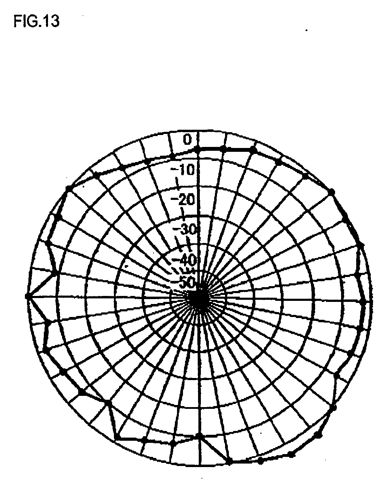

From now on, Figures show directivity curves in case of implementing the technique to improve the directivity of Transmitting antenna 17 with Retaining member M secured onto Mounting Hole 15 as described above. Figure 12 is a directivity curve without securing Retaining member M onto Mounting Hole 15. In other words, it is an initial specification of PC Card 10 having a radio feature. Figure 12 shows the directivity curve where Transmitting antenna 17 is located at the center of the circular graph. The axis extending outwards from the center of the circular graph indicates gain. This indicates that the initial specification of PC Card 10 has a directivity curve slightly inclined to the right forward. Figure 13 is a directivity curve with Retaining member M secured onto Mounting Hole 15. Figure 13 shows that the directivity curve is entirely adjustable and that the gain has increased generally. From the above, it is indicated that Retaining member M is functioning as reflector of Transmitting antenna 17.

### (4) PC Card Variant Examples

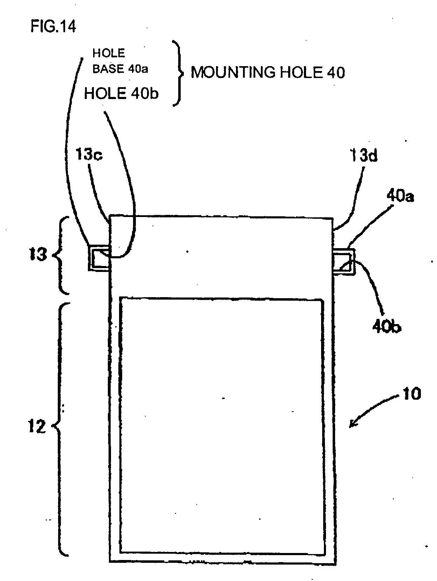

In the embodiments referred to above, Mounting Holes 14 and 15 to which Antitheft Wire 30 is fitted are formed to pierce PC Card 10 from Upper Surface 13a to Lower Surface 13b at Back part 13. From the viewpoint that the hole to fit Antitheft Wire 30 is formed at Back part 13 protruding out of Slot 21, however, the configuration is not limited to the mode in which the wire is made to pierce PC Card 10 from Upper Surface 13a to Lower Surface 13b. Given in Figures 14 to 19 are the variant examples of the mounting hole formed on Back part 13 of PC Card 10.

Figure 14 is a block diagram of the PC card showing the first variant example of a mounting hole.

In Figure 14, Mounting Hole 40 is formed on Sides 13c and 13d at Back part of PC Card 10. This Mounting Hole 40 is composed of Hole Base 40a and of Hole 40b, with Hole Base 40a erected outside Sides 13c and 13d. And this Hole 40b is formed to pierce from the upper surface to the lower surface of Back part 13 through Hole Base 40a erected on Sides 13c and 13d.

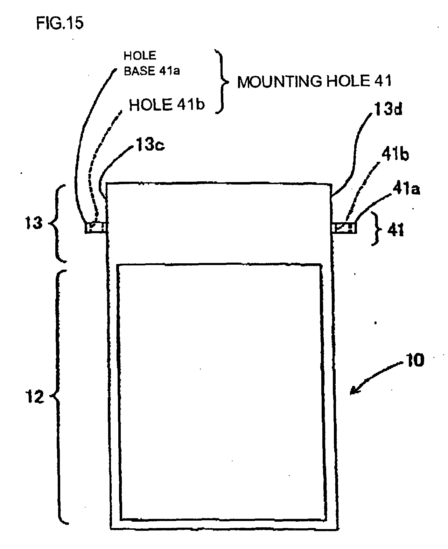

Figure 15 is a block diagram of the PC card showing the second variant example of a mounting hole.

In Figure 15, Mounting Hole 41 is formed on Sides 13c and 13d at Back part 13 of PC Card 10. This Mounting Hole 41 is composed of Hole Base 41a and of Hole 41b, with Hole Base 41a erected outside Sides 13c and 13d. And Hole 41b is formed to pierce from the front to the rear of Back part 13 through Hole Base 41a erected on Sides 13c and 13d.

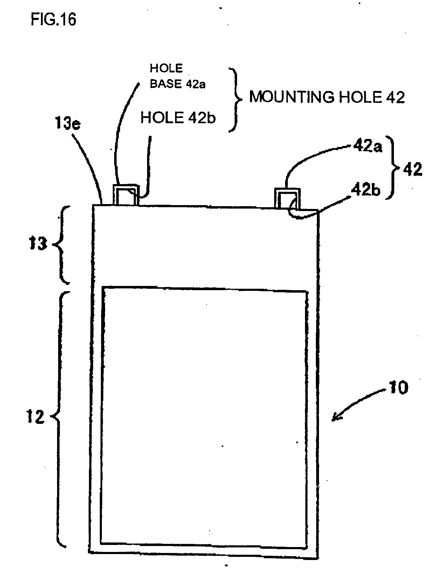

Figure 16 is a block diagram showing the third variant example of a mounting hole.

In Figure 16, Mounting Hole 42 is formed on End 13e at Back part 13 of PC Card 10. This Mounting Hole 42 is composed of Hole Base 42a and of Hole 42b, with Hole Base 42a erected outside End 13e. And Hole 42b is formed to pierce from the upper surface to the lower surface of Back part 13 through Hole Base 42a erected on End Side 13e.

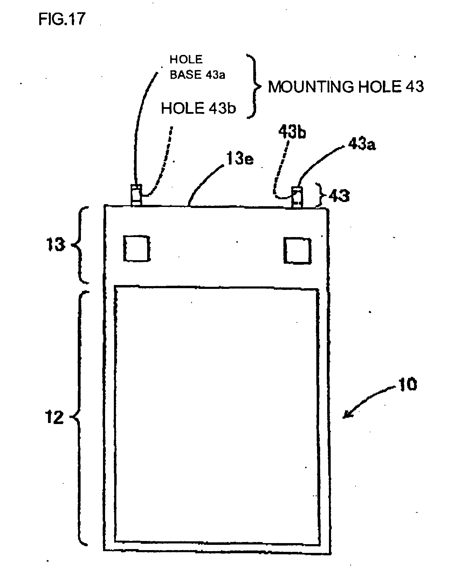

Figure 17 is a block diagram showing the fourth variant example of a mounting hole.

In Figure 17, Mounting Hole 43 is formed on End 13e at Back part 13 of PC Card 10. This Mounting Hole 43 is composed of Hole Base 43a and of Hole 43b, with Hole Base 43a erected outside End 13e. And Hole 43b is formed to pierce in the short sides of Back part 13 through Hole Base 43a erected on End Side 13e.

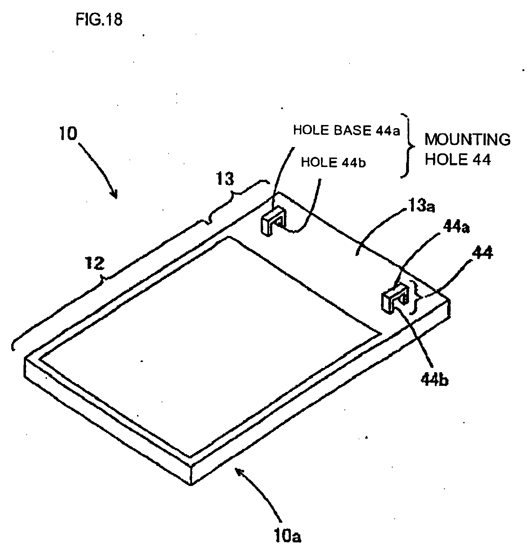

Figure 18 is a block diagram showing the fifth variant example of a mounting hole.

In Figure 18, Mounting Hole 44 is formed on Upper Surface 13a at Back part 13 of PC Card 10. This Mounting Hole 44 is composed of Hole Base 44a and of Hole 44b, with Hole Base 44a erected outside Upper Surface 13a. And Hole 44b is formed to pierce in the short sides of Back part 13 through Hole Base 44a erected on Upper Surface 13a. In this case, the configuration in which Mounting Hole 44 is formed on Lower Surface 13b at Back part 13 may be employed.

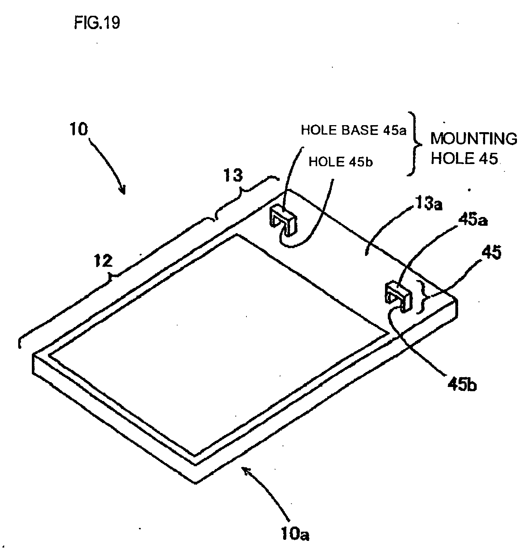

Figure 19 is a block diagram showing the sixth variant example of a mounting hole.

In Figure 19, Mounting Hole 40 is formed on Sides 13c and 13d at Back part 13 of PC Card 10. This Mounting Hole 40 is composed of Hole Base 40a and of Hole 40b, with Hole Base 40a erected outside Sides 13c and 13d. And Hole 40b is formed to pierce from the upper surface to the lower surface of Back part 13 through Hole Base 40a erected on Sides 13c and 13d. In this case, Mounting Hole 45 may be formed on Lower Surface 13b.

Even in the first to sixth variant examples as described above, it is needless to say that Retaining member M is mountable. In such a case, Ground Area 17b may be laid out on the inner circumference of Hole Bases 40 to 45 and brought into contact with Retaining member M fitted to Mounting Holes 40 to 45 so as to improve the directivity of Transmitting antenna 17. Or Ground Area 17b may be laid out as exposed in place at Back part 13 and brought into contact with Retaining member M fitted to Mounting Holes 40 to 45 so that Transmitting Antenna 17 will improve its directivity.

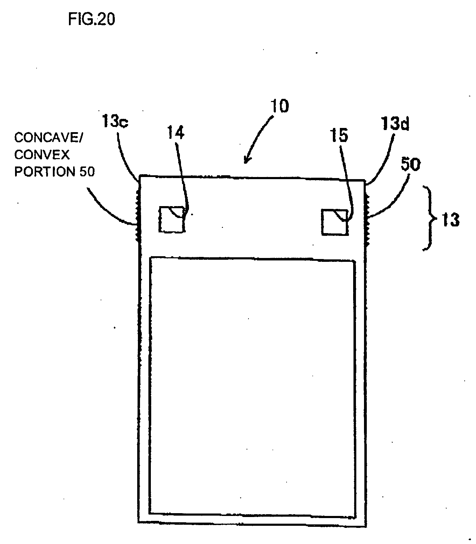

PC Card 10 is attached and detached to and from Slot 21 while being held at Rear End 13 by the user. In this case, a non-slip means, if any, on the side at Back part 13, is adequate to attach and detach the PC card. Figure 20 is a block diagram of the PC card, on which a non-slip shape is formed. In Figure 20, Concave/Convex Portion 50 shaped into a concave/convex condition is laid out on Sides 13c and 13d at Back part 13 of PC Card 10. This permits the user to hold Concave/Convex Portion 50 so that the user may stably carry out an operation of attaching/detaching PC Card 10.

In this embodiment, Mounting Holes 14 and 15 are formed on PC Card 10. With Antitheft Wire 30 fitted to this Mounting Hole 14 or 15, such a configuration is employed that the PC Card 10 can be protected against a possible theft. As a matter of course, however, a card-shaped medium attachably / detachably mounted on Computer 20 is not limited to PC Card 10 only. It is needless to say, therefore, that a card-shaped medium, such as an IC card or the like, may have a mounting hole formed to prevent theft, with Antitheft Wire 30 or the like fitted to such mounting hole.

### (5) Summary

With PC Card 10 mounted in Slot 21 of Computer 20 as described above, Back part 13 protrudes in the exterior. At the back part, Mounting Holes 14 and 15 are formed, in which Antitheft Wire 30 fitted to Computer Side Mount 24 is provided so that PC Card 10 cannot be removed from Computer 20. Consequently, it is possible to protect the PC Card 10 against theft. With Retaining member M fitted to such Mounting Hole 15, it is possible to improve the directivity of Transmitting antenna 17.

### Industrial Applicability

The invention aims to provide a card-shaped medium capable of protection against theft.

The invention of Claims 2 to 8 presents an embodiment of how the mounting holes are formed.

The invention of Claim 9 improves the directivity of the built-in transmitting antenna of the card-shaped medium.

The invention of Claim 10 prepares various alternatives of the mounting holes to improve the directivity of the transmitting antenna.

The invention of Claim 11 describes the retaining member that is simple in shape.

The invention of Claim 12 improves the directivity of the transmitting antenna.

The invention of Claim 13 prepares various alternatives of attachment point of the card-shaped medium to the computer, the point permitting an antitheft wire to be fitted thereto.

The invention of Claim 14 describes a user-friendly design of the card-shaped medium for inserting/removing the card into/from the computer.

## Claims

1. A card shaped-medium, substantially rectangular in shape, having a card body including a front part to be inserted in a slot formed in a computer, and a back part that projects from the computer when the front part is inserted in the slot of the computer; wherein the back part is provided with mounting holes through which predetermined members are mounted.

2. The card-shaped medium according to claim 1, wherein the mounting holes are formed in projections projecting backward from the end surface of the back part such that the axes thereof extend substantially parallel to the long sides of the card body.

3. The card-shaped medium according to claim 1, wherein the mounting holes are formed in projections laterally projecting from the side surfaces of the back part such that the axes thereof extend substantially perpendicularly to a plane including a major surface of the card body.

4. The card-shaped medium according to claim 1, wherein the mounting holes are formed in projections projecting backward from the end surface of the back part such that the axes thereof extend substantially parallel to the short sides of the card body.

5. The card-shaped medium according to claim 1, wherein the mounting holes are formed in projections projecting backward from the end surface of the back part such that the axes thereof extend substantially perpendicularly to a plane including a major surface of the card body.

6. The card-shaped medium according to claim 1, wherein the mounting holes are formed in projections projecting upward from the upper surface of the back part or in projection projecting downward from the lower surface of the back part such that the axes thereof extend substantially parallel to the long sides of the card body.

7. The card-shaped medium according to claim 1, wherein the mounting holes are formed in projections projecting upward from the upper surface of the back part or in projection projecting downward from the lower surface of the back part such that the axes thereof extend substantially parallel to the short sides of the card body.

8. The card-shaped medium according to claim 1, wherein the mounting holes are formed so as to extend between the upper and the lower surface of the back part.

9. The card-shaped medium according to any one of claims 1 to 8 further comprising: a retaining member to be passed through the mounting hole; a transmitting antenna embedded in the card body; and a grounding part connected to a grounding terminal for the transmitting antenna and capable of coming into contact with part of the retaining member as passed through the mounting hole.

10. The card-shaped medium according to claim 9, wherein the grounding part is formed on the side surface of the through hole.

11. The card-shaped medium according to 9 or 10, wherein the retaining member is formed a shape substantially resembling the letter L by perpendicularly connecting first and second retaining parts, the first retaining part is passed through the hole extending between the upper and the lower surface of the back part, and the second part is placed on the upper or the lower surface of the back part.

12. The card-shaped medium according to claim 11, wherein the transmitting antenna is extended substantially perpendicularly to a direction in which the card body is inserted in the slot, and the second retaining part is disposed in parallel to the transmitting antenna on the upper or the lower surface of the back part.

13. The card-shaped medium according to any one of claims 1 to 12, wherein the mounting holes are arranged symmetrically with respect to the longitudinal center axis of the card body.

14. The card-shaped medium according to any one of claims 1 to 13, wherein the side surfaces of the back part are formed in an antislipping morphology.
